# EUROPEAN PATENT APPLICATION

(11) **EP 0 595 054 A1**
(43) Date of publication of application: **04.05.1994**
(21) Application number: 93115802.6
(22) Date of filing: 30.09.1993
(51) Int. Cl.: C23C 16/44

(54) **Method for processing semiconductor wafers at temperatures exceeding 400 degrees C.**

(30) Priority: 30.10.1992 US 968710
(71) Applicant: APPLIED MATERIALS, INC., Santa Clara California 95052-8039 (US)
(72) Inventor: Telford, Susan G., Mountain View, California 94043 (US); Chang, Mei, Cupertino, California 95014 (US); Chew, Sandy, Fremont, California 94536 (US)
(74) Representative: Kahler, Kurt, Dipl.-Ing.

(57) **Abstract**

A method is described for processing a semiconductor wafer in a reactor at a wafer support temperature in excess of 400°C, and preferably at least about 550°C or higher, without warpage while providing corrosion resistance to the chemicals used in the reactor during such processing which comprises processing the semiconductor wafer, in a reactor containing process apparatus, such as a wafer support or susceptor, comprising graphite materials coated with a protective layer of aluminum nitride.

## Description

### BACKGROUND OF THE INVENTION

### 1. Field of the Invention

This invention relates to a method for processing semiconductor wafers at temperatures exceeding 400°C. More particularly, this invention relates to the processing of semiconductor wafers at temperatures exceeding 400°C in a semiconductor wafer processing reactor using aluminum nitride-coated graphite materials capable of withstanding warpage at such temperatures and which exhibit corrosion-resistance to reactants used to form coatings on the semiconductor wafers at such temperatures.

### 2. Description of the Related Art

In the processing of semiconductor wafers to form integrated circuit structures thereon, various materials such as silicon oxide, silicon nitride, polysilicon, photoresist, and aluminum, are processed, e.g., formed or etched, on the wafer. Conventionally, for many of such processes, the semiconductor wafer is placed in a reactor on a wafer support while the coating material is applied to the wafer (or etched on the wafer), such as by CVD, plasma CVD, or PVD techniques. Usually, the material is processed, i.e., deposited, grown, etched, etc., on the wafer in the presence of heat as well as various gases.

It is, therefore, important that the apparatus used within the reactor, such as the wafer support or susceptor, showerhead, etc. be constructed of materials capable of withstanding the operating temperatures, e.g., without warpage. It is equally important that the materials used to form such apparatus be capable of withstanding corrosion at such operating temperatures from the chemicals used during the wafer processing.

The use of aluminum materials such as aluminum susceptors, showerheads, clamping rings, etc., has, in most instances, been found to be satisfactory for such processing, from the standpoint of heat resistance and corrosion resistance, if needed, is usually achievable by providing a coating such as an anodized aluminum oxide coating on the surface of the aluminum process apparatus.

More recently, however, other materials such as tungsten, tungsten silicide, titanium-tungsten, titanium nitride, and titanium silicide have been used in semiconductor processing to form integrated circuit structures on the wafer. The use of such materials often requires the use of processing temperatures in excess of 400°C.

For such applications, to avoid warpage, it is preferable to use a material such as graphite as the susceptor instead of aluminum, since graphite will not exhibit any warpage at temperatures used in semiconductor wafer processing. However, it has been found that graphite materials, such as susceptors, do not exhibit sufficient corrosion resistance at such temperatures, i.e. at temperatures above 400°C, and sometimes above 550°C, to the chemicals used in the formation and processing of materials such as tungsten, titanium nitride, etc.

It would, therefore, be desirable to provide a method for processing semiconductor wafers at temperatures in excess of 400°C which would not result in warpage of the apparatus used in the reactor for the formation of such coatings and would provide corrosion resistance for such apparatus to the chemicals used in the processing of the wafers.

### SUMMARY OF THE INVENTION

The invention comprises a method for processing a semiconductor wafer in a reactor at temperatures in excess of 400°C, and preferably at least about 550°C or higher, without warpage while providing corrosion resistance to the chemicals used in the reactor during such processing which comprises processing the semiconductor wafer in a reactor containing process apparatus, such as a wafer support or susceptor, comprising graphite materials coated with a protective layer of aluminum nitride.

### BRIEF DESCRIPTION OF THE DRAWINGS

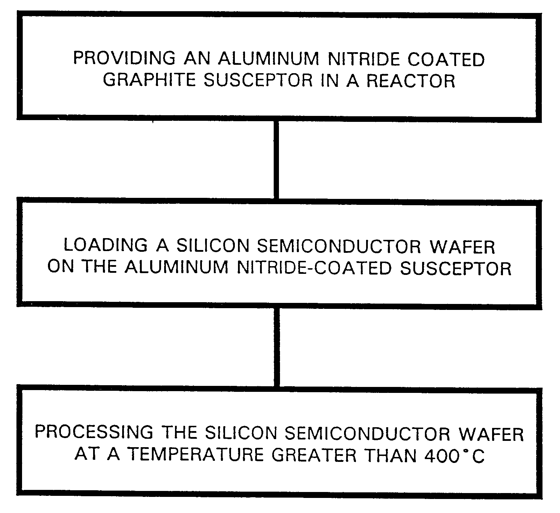

The sole drawing is a flowsheet illustrating the method of the invention.

### DETAILED DESCRIPTION OF THE INVENTION

The invention comprises a method for processing semiconductor wafers at temperatures in excess of 400°C in the presence of chemical reagents which normally attack graphite and silicon carbide-coated graphite process apparatus used in the formation and processing of materials such as tungsten, tungsten silicide, titanium nitride, etc., wherein the process apparatus such as the susceptor will not warp and will exhibit corrosion resistance to such chemicals.

In accordance with the invention, the method comprises processing the semiconductor wafer in a reactor, at a temperature exceeding 400°C, using processing apparatus comprising graphite coated with aluminum nitride. In a preferred embodiment, the method of the invention may be practiced at temperatures of at least about 550°C or higher.

Such process apparatus includes the wafer support or susceptor on which the wafer rests in the reactor during the processing. The process apparatus may also comprise the gas inlet or showerhead which sometimes functions as the other electrode when the wafer support is connected to one side of an RF power supply. The process apparatus may further comprise clamping means such as a clamping ring or fingers, as well as a shadow ring used to mask the periphery of the wafer during depositions and/or etching of the wafer. Any and all electrodes utilized within the process reactor may further comprise process apparatus consisting of graphite electrodes protected by an aluminum nitride coating thereon.

The aluminum nitride-coated graphite process apparatus such as, by way of example and not of limitation, an aluminum nitride-coated graphite susceptor, may be first fabricated from uncoated graphite, i.e., machined or otherwise formed, and then coated with the protective aluminum nitride layer by any suitable coating process, such as, for example, by CVD or PVD processing.

However, while it is necessary, from the standpoint of resistance to warpage, that such process apparatus be fabricated from a material such as graphite capable of withstanding temperatures above about 400°C, and preferably at about 550°C or higher, it will be appreciated that to render the process apparatus resistant to corrosion by the chemicals used in processing the semiconductor wafer, such process apparatus could also be covered by thin sheets of material, e.g., graphite, coated with aluminum nitride on one surface while the opposite surface is bonded to the process apparatus to be protected by such aluminum nitride coating.

This latter method of rendering the process apparatus corrosion resistant to the chemicals present in the reactor during such high temperature processing is somewhat similar to current technology employed with aluminum process apparatus such as susceptors and clamping rings wherein ceramic materials are bonded to the surface of the aluminum to provide resistance to corrosive attack by chemicals used in the reactor during processing of semiconductor wafers therein, except that in accordance with the invention, an aluminum nitride surface will be used to provide corrosion resistance to the underlying graphite at high temperatures, i.e., temperatures above about 400°C, and in some instances, at about 550°C or higher.

The following examples will serve to further illustrate the process of the invention.

### Example I

An aluminum nitride-coated graphite susceptor in a reactor chamber was heated to a temperature of 475°C. NF₃ was flowed into the chamber, at a rate of 150 sccm, through a standard aluminum (AA6061) showerhead, and argon gas was also flowed into the chamber through the showerhead at a rate of 150 sccm. A total pressure of 80 Pa (600 milliTorr) was maintained in the chamber. A plasma was initiated between the showerhead and the susceptor in the chamber and maintained at a power level of 300 watts for 147 hours. The plasma was then extinguished and the susceptor was allowed to cool to room temperature. The susceptor was then removed from the reactor and examined, both visually and by SEM cross-section. No significant loss of coating thickness on the susceptor was ascertained, indicating that the aluminum nitride coating on the susceptor was providing corrosion resistance to the graphite susceptor which would (in an uncoated condition) normally show significant attack by the NF₃ plasma when exposed for this length of time and this high a temperature. There was also no evidence of susceptor warpage, as measured by flatness profile.

### Example II

To further illustrate the method of the invention, 15,24 cm (six inch) diameter silicon semiconductor wafers, some of them with no coating material previously applied thereto, and some with a prior coating of titanium nitride thereon, were each coated with tungsten in an Applied Materials P5000 tungsten system reactor chamber. The aluminum nitride-coated graphite susceptor in the chamber was maintained at a temperature of 475°C and deposition occurred by flowing WF₆ into the chamber at a rate of about 100 sccm and H₂ at a rate of about 600 sccm for about 2 minutes.

After applying tungsten coatings to 500 of such wafers, the aluminum nitride-coated graphite susceptor was removed from the chamber and examined for corrosion attack. There were no signs of corrosion attack on the coated graphite susceptor noted either visually by the naked eye or under an 80x microscope. There was also no evidence of susceptor warpage, as measured by flatness profile.

### Example III

To further ascertain the protection against corrosive attack by Si₂Cl₂H₂ afforded to the graphite wafer by the aluminum nitride coating thereon, tungsten silicide coatings were deposited on a number of 20,32 cm (eight inch) diameter silicon semiconductor wafers, in a similar reactor chamber to that previously described, by mounting each wafer on an aluminum nitride-coated graphite susceptor designed to accommodate 20,32 cm (eight inch) diameter wafers thereon. In each instance, 200 sccm of Si₂Cl₂H₂ and 10 sccm of WF₆ was flowed into the chamber. About 75% of the wafers were coated with tungsten silicide while the susceptor was maintained at a temperature of about 550°C, and the susceptor was maintained at a temperature of about 600°C while the other 25% of the wafers were coated with tungsten silicide. After 400 wafers were coated with tungsten silicide in this manner, the aluminum nitride-coated graphite susceptor was removed from the chamber and examined in the same manner as in Example II. Again no signs of corrosion or coating loss were ascertainable either to the naked eye or under an 80x microscope, and there was no evidence of susceptor warpage.

Thus, the invention provides a method for processing semiconductor wafers in a reactor chamber at a temperature above 400°C without warpage to the process apparatus and while providing corrosion resistance to attack of the process apparatus by the chemicals used in the processing.

## Claims

1. A method for processing a semiconductor wafer in a reactor at a wafer support temperature above about 400°C which comprises processing said wafer with aluminum nitride-coated graphite process apparatus.

2. The method of claim 1,
wherein said method further comprises processing said semiconductor wafer in said reactor while maintaining said wafer support temperature at least about 550°C.

3. The method of claim 1 or 2,
wherein said method further comprises processing said semiconductor wafer in said reactor while said wafer is supported in said reactor on an aluminum nitride-coated graphite wafer support.

4. The method of claim 3,
wherein said method further comprises processing said semiconductor wafer in said reactor while said wafer is secured to said aluminum nitride-coated graphite wafer support by aluminum nitride-coated graphite clamping means.

5. The method of any of claims 1 to 4,
wherein said method further comprises processing said semiconductor wafer in said reactor while peripheral portions of said wafer are shielded by an aluminum nitride-coated graphite shadow ring.

6. The method of any of claims 1 to 5,
wherein said method further comprises processing said semiconductor wafer in said reactor while process gases are flowed into said reactor through an aluminum nitride-coated graphite showerhead.

7. The method of any of claims 1 to 6,
wherein said method further comprises processing said semiconductor wafer in said reactor while maintaining a plasma between aluminum nitride-coated graphite electrodes in said reactor.

8. The method of any of claims 1 to 7,
wherein said method further comprises forming tungsten on said semiconductor wafer by flowing WF₆ gas into said reactor.

9. The method of any of claims 1 to 7,
wherein said method further comprises forming tungsten silicide on said semiconductor wafer by flowing a mixture of WF₆ and Si₂Cl₂H₂ gases into said reactor.

10. A method for processing a semiconductor wafer in a reactor at a wafer support temperature above about 400°C which comprises supporting said wafer on an aluminum nitride-coated graphite wafer support while processing said wafer in said reactor.

11. The method of claim 10,
wherein said method for processing a semiconductor wafer in a reactor further comprises processing said wafer at a wafer support temperature of at least about 550°C.

12. The method of claim 10 or 11,
wherein said method further comprises supporting said semiconductor wafer in said reactor on an aluminum nitride-coated graphite susceptor.

13. A method for processing a semiconductor wafer in a reactor which comprises supporting said wafer on an aluminum nitride-coated graphite susceptor maintained at a temperature of at least about 400°C while processing said wafer in said reactor.

14. The method of claim 13 wherein said method for processing a semiconductor wafer in a reactor while supporting said wafer on an aluminum nitride-coated graphite susceptor further comprises maintaining said aluminum nitride-coated graphite susceptor processing said wafer at a temperature of at least about 550°C.

15. The method of claim 13 or 14,
wherein said method further comprises forming tungsten on said semiconductor wafer by flowing WF₆ gas into said reactor.

16. The method of claim 13 or 14,
wherein said method further comprises forming tungsten silicide on said semiconductor wafer by flowing a mixture of WF₆ and Si₂Cl₂H₂ gases into said reactor.
